# EUROPEAN PATENT APPLICATION

(11) **EP 4 209 794 A1**
(43) Date of publication of application: **12.07.2023**
(21) Application number: 20950482.8
(22) Date of filing: 04.09.2020
(51) Int. Cl.: G01R 31/392

(54) **INFORMATION PROCESSING DEVICE, INFORMATION PROCESSING METHOD, INFORMATION PROCESSING SYSTEM, AND PROGRAM**

(71) Applicant: Kabushiki Kaisha Toshiba, Minato-ku Tokyo 105-0023 (JP); Toshiba Energy Systems & Solutions Corporation, Kawasaki-shi, Kanagawa 212-0013 (JP)
(72) Inventor: YAMAMOTO, Takahiro, Tokyo 105-0023 (JP); HATANO, Hisaaki, Tokyo 105-0023 (JP); MARUCHI, Kohei, Tokyo 105-0023 (JP); MITSUMOTO, Kenji, Kawasaki-shi, Kanagawa 212-0013 (JP)
(74) Representative: Marks & Clerk LLP
(86) International application number: PCT/JP2020/033695
(87) International publication number: WO 2022/049745

(57) **Abstract**

[Solution] According to one embodiment, an information processing apparatus includes: an SoH calculator to calculate an SoH (State of Health) for each of a plurality battery units on the basis of measurement data related to an electric power applied to each of the plurality of battery units in a rechargeable battery; a maximum/minimum voltage SoH calculator to calculate a maximum/minimum voltage SoH which is an SoH based on a maximum voltage and a minimum voltage in voltages applied to a plurality of cells or a plurality of battery subunits in the battery unit for each of the plurality of battery units on the basis of the measurement data; and an SoH ratio calculator to calculate an SoH ratio which is a ratio of the maximum/minimum voltage SoH to the SoH for each of the plurality of battery units on the basis of the calculated SoH and the calculated maximum/minimum voltage SoH.

## Description

### [Technical Field]

Embodiments of the present invention relate to an information processing apparatus, an information processing method, an information processing system, and a program.

### [Background Art]

A variety of technologies for estimating an SoH (State of Health) of a battery are proposed for detecting a battery deterioration at an early stage. For example, a voltage standard deviation method is known, which aims at identifying the SoH by statistically processing a relationship between a State of Charge (SoC) and a voltage on the basis of operation data of the battery. As a method of detecting a deterioration sign, it is effective to use an SoH gradient based on a data string including a charge-and-discharge electric energy, an equivalent cycle number given by normalizing charge-and-discharge electric energy with a capacity defined in a system specification and an SoH: however, there arises a problem of how to set a data period and a threshold value of a deteriorating acceleration for calculating the SoH gradient, which may causes a problem that a doubt about detection accuracy occurs, depending on how the threshold value and the data period are set.

### [Citation List]

### [Patent Documents]

[Patent Document 1] Japanese Patent Publication No. 5386443
[Patent Document 1] Japanese Patent Publication No. 6134438

### [Non-Patent Documents]

[Non-Patent Document 1] "Method to Evaluate State of Health of Lithium-Ion Batteries Used in In-Service BESS for Electric Power System", Toshiba Review vol. 73, No. 6, November in 2018, Toshiba Corp.

### [Summary of the Invention]

### [Technical Problem]

Embodiments of the present invention provide an information processing apparatus to generate deterioration sign information of a battery system with high accuracy.

### [Solution to Problem]

According to one embodiment, an information processing apparatus includes: an SoH calculator to calculate an SoH (State of Health) for each of a plurality battery units on the basis of measurement data related to an electric power applied to each of the plurality of battery units in a rechargeable battery; a maximum/minimum voltage SoH calculator to calculate a maximum/minimum voltage SoH which is an SoH based on a maximum voltage and a minimum voltage in voltages applied to a plurality of cells or a plurality of battery subunits in the battery unit for each of the plurality of battery units on the basis of the measurement data; and an SoH ratio calculator to calculate an SoH ratio which is a ratio of the maximum/minimum voltage SoH to the SoH for each of the plurality of battery units on the basis of the calculated SoH and the calculated maximum/minimum voltage SoH.

### [Brief Description of Drawings]

[FIG. 1] A block diagram illustrating one example of an information processing apparatus according to one embodiment of the present invention.
[FIG. 2] A diagram illustrating a first example of a configuration of a rechargeable battery as a detection target of deteriorating acceleration.
[FIG. 3] A diagram illustrating a second example of the configuration of the rechargeable battery as the detection target of deteriorating acceleration.
[FIG. 4] A chart illustrating transitions of an SoH.
[FIG. 5] A chart illustrating transitions of a maximum/minimum voltage SoH.
[FIG. 6] A chart illustrating an SoH ratio.
[FIG. 7] A graphic chart illustrating comparisons between the SoH, the maximum/minimum voltage SoH and the SoH ratio.
[FIG. 8] An outline flowchart of whole processes of the information processing apparatus.
[FIG. 9] An outline flowchart illustrating specific examples of a detection and an output.
[FIG. 10] An outline flowchart of a process of calculating the maximum/minimum voltage SoH.
[FIG. 11] A block diagram illustrating one example of a hardware configuration in one embodiment of the present invention.

### [Description of Embodiments]

Embodiments of the present invention will hereinafter be described with reference to the drawings.

### (Embodiments of the Invention)

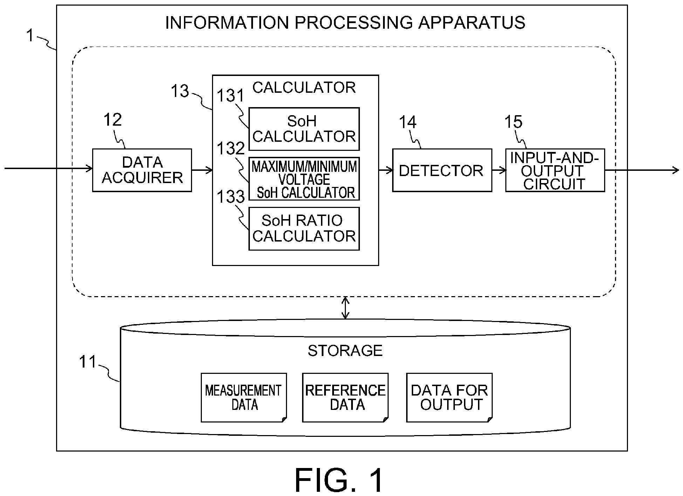

FIG. 1 is a block diagram illustrating an information processing apparatus 1 according to the embodiment of the invention. The information processing apparatus 1 according to the embodiment includes a storage 11, a data acquirer 12, a calculator 13, a detector 14, and an input-and-output circuit 15. The calculator 13 includes an SoH calculator 131, a maximum/minimum voltage SoH calculator 132, and an SoH ratio calculator 133.

The information processing apparatus 1 is an apparatus to generate information that is, in other words, an index of a deteriorating acceleration of a rechargeable battery. The deteriorating acceleration of the rechargeable battery is detected based on the index information and may also be detected by the information processing apparatus 1 or by an external apparatus. For example, it is also considered for a cloud server to collect the items of battery information via a communication network and detect the deteriorating acceleration. In the embodiment, the information processing apparatus 1 including the detector 14 is thus configured to detect the deteriorating acceleration for the sake of explaining the detection of the deteriorating acceleration.

The rechargeable battery as a detection target of the deteriorating acceleration is a rechargeable battery capable of accumulating electricity (charging) and discharging the electric energy. Further, the rechargeable battery includes a plurality of unit batteries (cells each) separated into a plurality of battery units, and the plurality of battery units are exemplified by a battery module and a battery board as in a battery energy storage system (BESS). In the embodiment, a deterioration of the battery unit is detected, and the deterioration of the rechargeable battery is detected based on the detection of the battery unit.

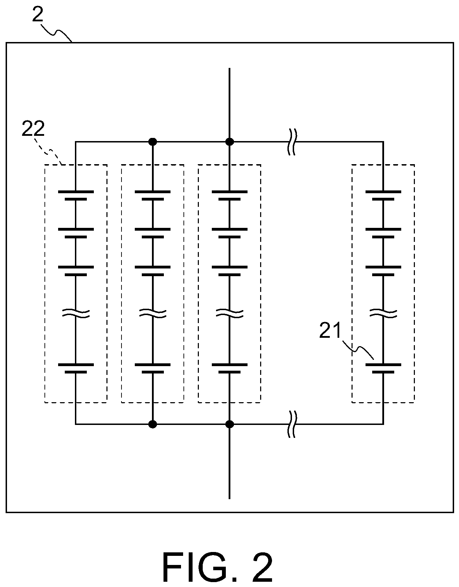

FIG. 2 is a diagram illustrating a first example of a configuration of the rechargeable battery as the detection target of the deteriorating acceleration. In the example of FIG. 2, a rechargeable battery 2 is configured by a plurality of battery modules 22 each including a plurality of cells 21 connected in series. The plurality of battery modules 22 are connected in parallel. In the example of FIG. 2, the battery module 22 corresponds to the battery unit described above.

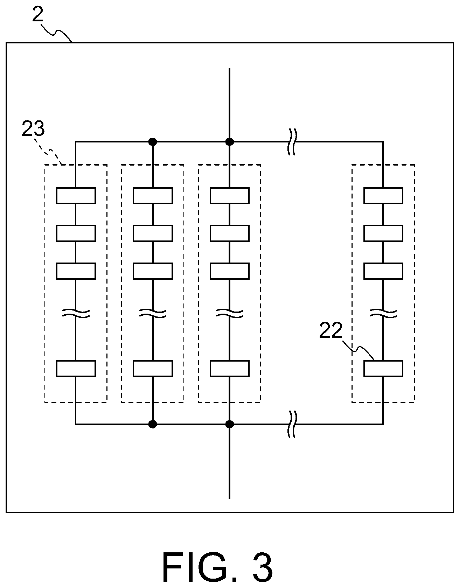

FIG. 3 is a diagram illustrating a second example of the configuration of the rechargeable battery as the detection target of the deteriorating acceleration. In the example of FIG. 3, the rechargeable battery 2 is configured by a plurality of battery boards 23 each including the plurality of battery modules 22 connected in series. The plurality of battery boards 23 are connected in parallel. Each of the plurality of battery modules 22 includes one or more cells. In the example of FIG. 3, the battery board 23 corresponds to the battery unit described above. Note that a different battery unit is contained in the battery unit as in the battery modules 22 contained in the battery board 23, in which case the different battery unit in the battery unit is referred to as a battery subunit. Note that a configuration of each of the cells included in the plurality of battery modules 22 may not be the configuration as in the example of FIG. 2.

Note that a number of the cells or the battery subunits in each battery unit may be the same and may also be different. The battery subunits in each battery unit are arrayed such that voltages applied in a same deteriorating state are substantially same. As in FIG. 2, each battery unit includes none of the battery subunits, in which case the respective cells in each battery unit are arrayed such that the voltages applied to the cells in the same deteriorating state are substantially same.

Parameters of a voltage, a current, a temperature and other parameters of each battery unit are measurable and transmitted as measurement data to the information processing apparatus 1. For example, a BMU (Battery Management Unit), a CMU (Cell Monitoring Unit) and other units possessed by the BESS may measure the parameters of the battery unit, and devices capable of measuring the parameters of the battery unit may also be provided in the rechargeable battery 2. Note that the measurement data may be transmitted by the rechargeable battery 2 directly to the information processing apparatus 1 and may also be transmitted via a device or its equivalent to collect the items of information of the rechargeable battery 2. The measurement data of the rechargeable battery 2 being in operation are thus obtained, thereby enabling the deteriorating acceleration of the battery unit to be monitored even in the operating status of the rechargeable battery 2. For example, short-cycle charging/discharging is performed for 24 hours 365 days in the BESS, and however, the present embodiment enables soundness evaluation of the BESS to be carried out without stopping the BESS. However, the deteriorating acceleration at the past time point may be estimated based on the measurement data in the past, and the rechargeable battery being in non-operation may also be evaluated.

The measurement data about each battery unit contain at least data necessary for calculating the SoH of the rechargeable battery 2. The SoH is an index that indicates the state of deterioration of the rechargeable battery 2. Note that it may be properly set how a deteriorating state of a rechargeable device is indicated. For instance, the deteriorating state may be defined by using a full-charge capacity decreasing due to the deterioration and an internal resistance increasing due to the deterioration.

In the present description, the SoH is set as a ratio of the full-charge capacity at an evaluation time point to a full-charge capacity prescribed in specifications of the battery unit (Ratio of Full-Charge Capacity at Evaluation Time/Full-Charge Capacity Prescribed in Specifications). The evaluation time point may be an arbitrary time point. For example, the measurement data are saved on a daily basis often as a CSV file containing measurement results for one day in the BESS described above. An electric power energy handled on the day can be calculated from the measurement data for one day, and hence a time point when saving the measurement data may also be set as the evaluation time point. In the BESS, e.g., an SoH transition run chart with an axis of abscissa indicating the electric power energy and an axis of ordinate indicating the SoH may be generated based on the measurement results. Similarly to this BESS, the SoH with respect to an cumulative equivalent cycle number up to an arbitrary evaluation time point may also be calculated.

However, the SoH may further be set as a ratio of the full-charge capacity at a second time point to the full-charge capacity at a first time point (Full-Charge Capacity at Second Time point/Full-Charge Capacity at First Time point). The first time point and the second time point are arbitrary time points, in which the second time point is posterior to the first time point, and the deterioration of the battery unit progresses at the second time point farther than at the first time point. The first time point may also be a not-yet-used time point, in which case the full-charge capacity at the first time point is generally set larger than the full-charge capacity prescribed in the specifications.

A method of calculating the SoH of the battery unit may involve using conventional methods. For example, the measurement data contain the voltages of the battery units, and a standard deviation or a variance of a distribution of voltage values is calculated based on time-series data of the voltages. A known SoH calculating method is that reference data representing a general relationship between the SoH and the standard deviation or the variance of the distribution of the voltage values are generated from the rechargeable batteries rendered deteriorating in a variety of states beforehand, and the SoH is calculated from the calculated standard deviation or variance on the basis of the reference data. The SoH may be calculated by use of the method described as such.

The measurement data further contain data representing whether the battery unit is in charging or discharging in order to calculate a maximum/minimum voltage SoH. For instance, a direction of current to charge and discharge the rechargeable battery is indicated by positive or negative of the current, in which case the measurement data contain the charging/discharging current for the rechargeable battery. The measurement data still further contain maximum and minimum values of the voltage values of the battery subunit included in the battery unit to calculate the maximum/minimum voltage SoH. As in FIG. 2, the battery unit does not include the battery subunit, in which case the measurement data contain the maximum and minimum values of the voltage values of the respective cells in the battery unit. Note that the measurement data may contain parameter values not used for calculating the SoH.

An internal configuration of the information processing apparatus 1 will be described. Note that components illustrated in FIG. 1 serve to detect the deteriorating acceleration, whereas other components are omitted. The respective components may be divided and may also be integrated. For instance, the storage 11 may be divided corresponding to files to be saved. The components other than the storage 11 may also be deemed as arithmetic units. A processing result of each component may be transmitted to the component that executes a next process and may also be stored in the storage 11; and the component, which executes the next process, may acquire the processing result from the storage 11 by accessing the storage 11.

The storage 11 stores the data used for the processing of the information processing apparatus 1. The data given as such are exemplified by the measurement data acquired from the rechargeable battery 2, the reference data for calculating the SoH and data for outputting an alert. Note that the data to be stored in the storage 11 are not limited, but, for instance, the processing results of the respective components of the information processing apparatus 1 may also be stored.

The data acquirer 12 acquires the measurement data from the rechargeable battery 2 and stores the acquired data in the storage 11. The stored measurement data are used as a history. For example, the transitions of the voltage applied to the respective battery units can be checked from the stored measurement data.

Note that the measurement data are acquired in real time from the rechargeable battery 2 and may be stored in the storage 11 by collecting the measurement data per unit time exemplified by one day into one file. Alternatively, for instance, the rechargeable battery 2 collects the measurement data per unit time into one file and may store the file in the storage 11 by transmitting the file thereto. The unit time and a saving format may be properly determined.

The calculator 13 generates information for detecting the deteriorating acceleration on the basis of the stored measurement data. In the example of FIG. 1, the calculator 13 is divided into the SoH calculator 131, the maximum/minimum voltage SoH calculator 132 and the SoH ratio calculator 133, corresponding to processing contents.

The SoH calculator 131 calculates, based on the stored measurement data, the SoH per battery unit of the rechargeable battery 2. For example, as stated above, the SoH calculator 131 calculates the standard deviation or the variance of the distribution of the voltage values of the battery unit per unit period exemplified by one day. Subsequently, the SoH calculator 131 calculates the SoH of the battery unit from the calculated standard deviation or variance on the basis of the reference data.

The maximum/minimum voltage SoH calculator 132 calculates, based on the stored measurement data, the maximum/minimum voltage SoH for every battery unit of the rechargeable battery 2. The maximum/minimum voltage SoH is the SoH based on the maximum voltage and the minimum voltage of the respective voltages applied to the battery subunits in the battery unit. The battery unit does not include the battery subunit, in which case the maximum/minimum voltage SoH is the SoH based on the maximum voltage and the minimum voltage of the respective voltages applied to the cells in the battery unit.

The cells or the battery subunits included in the battery unit have differences caused due to the deteriorations between values of internal resistances thereof. Therefore, the voltages of the cells or the battery subunits also come to differ, respectively. The maximum/minimum voltage SoH calculator 132 regards, as the voltage of the battery unit, the maximum voltage of the voltages applied to the cells or the battery subunits at charging time, and regards, as the voltage of the battery unit, the minimum voltage of the voltages applied to the cells or the battery subunits at discharging time. Similarly to the SoH calculator 131, the maximum/minimum voltage SoH calculator 132 calculates the SoH of the battery unit. In other words, the maximum/minimum voltage SoH calculator 132 calculates the SoH of the battery unit from maximum/minimum voltage data synthesized by using the maximum voltage of the internal cells or the battery subunits instead of the voltage of the battery unit at the charging time of the battery unit, and the minimum voltage of the internal cells or the battery subunits instead of the voltage of the battery unit at the discharging time of the battery unit, and sets the calculated SoH as the maximum/minimum voltage SoH.

The cell or the battery subunit exhibiting the maximum voltage at the charging time of the battery unit do not necessarily coincide with the cell or the battery subunit exhibiting the minimum voltage at the discharging time of the battery unit, in which these cells or the battery subunits are tentatively given as those exhibiting a maximum deterioration state in the cells or the battery subunits in the battery unit. To be specific, the maximum/minimum voltage SoH exhibits a possibility of a most progressing state of the deterioration in the battery unit, and therefore becomes a value smaller than the SoH.

Known is, e.g., a voltage standard deviation method capable of evaluating the SoH without stopping the rechargeable battery being in charging/discharging. The voltage standard deviation method involves using a plot locus chart with an X-coordinate indicating an SoC (State of Charge) of the cell being in charging/discharging and a Y-coordinate indicating a terminal voltage of the cell concerned. It is known with respect to the plots that a distribution along the Y-axis, in other words, a dispersion of the terminal voltage spreads corresponding to a decrease in the SoH even when the charging/discharging electric energy is the same. In the voltage standard deviation method, the SoH is estimated based on the distribution described above. When calculating the maximum/minimum voltage SoH by using this voltage standard deviation method, it follows that the locus chart has illustrations of the plot of the maximum voltage along the Y-coordinate and the plot of the minimum voltage along the Y-coordinate. Hence, the distribution along the Y-coordinate becomes extremely extensive. It is recognized from what is just described above that the maximum/minimum voltage SoH takes a value smaller than the SoH.

The SoH ratio calculator 133 calculates an SoH ratio for each battery unit. The SoH ratio represents a ratio of the maximum/minimum voltage SoH of the battery unit concerned to the SoH of the battery unit (Maximum/Minimum Voltage SoH/SoH). As stated above, the maximum/minimum voltage SoH depends on the most progressing state of the deterioration in the battery unit. On the other hand, the SoH depends on all of the cells or the battery subunits in the battery unit. Accordingly, the SoH ratio takes a value approximate to "1" when the most progressing state of the deterioration is substantially the same as those of other cells or battery subunits, but takes a value smaller than "1" when the most progressing state of the deterioration is larger than those of other cells or battery subunits. In other words, the SoH ratio represents how much the most progressing state of the deterioration in the battery unit progresses in deterioration as compared with other states. The SoH ratio is used as the index, thereby enabling such recognition that the deterioration progresses in a part of the internal cells or cell subs farther than other cells or battery subunits even when the whole battery unit appears to keep the soundness.

The detector 14 detects, based on the SoH ratios of the respective battery units, an alert target battery unit. In other words, a search for whether there exists the battery unit including an existence of the cell or battery subunit progressing in deterioration farther than other cells or battery subunits, is made based on the SoH ratio, and the detected (searched) battery unit is set as the alert target. Note that alert contents may properly be determined. For example, the battery unit being set as the alert target may be deemed to be deteriorated or broke down, and may also be deemed to have an apprehension of the sudden deterioration or breakdown hereafter. When detecting the alert target battery unit, the detector 14 may set the rechargeable battery 2 as the alert target in the same way with this battery unit. Namely, the rechargeable battery 2 may also be deemed to get deteriorated or broke down, and may further be deemed to have the apprehension of the sudden deterioration or breakdown hereafter. For instance, the battery unit may be detected as the alert target, corresponding to a degree of how much the SoH ratio is far from the value "1", and the alert contents may also be varied.

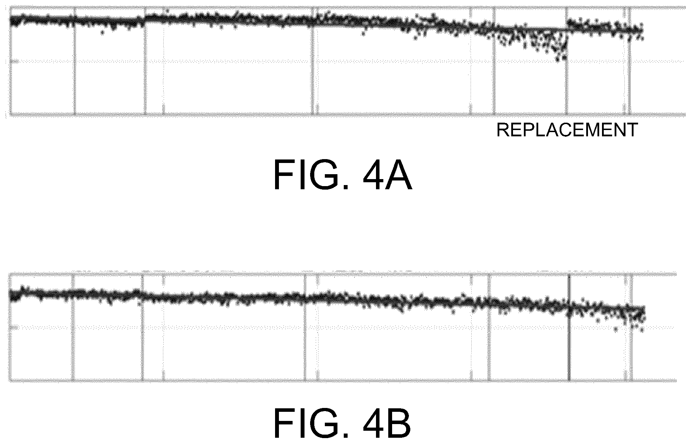

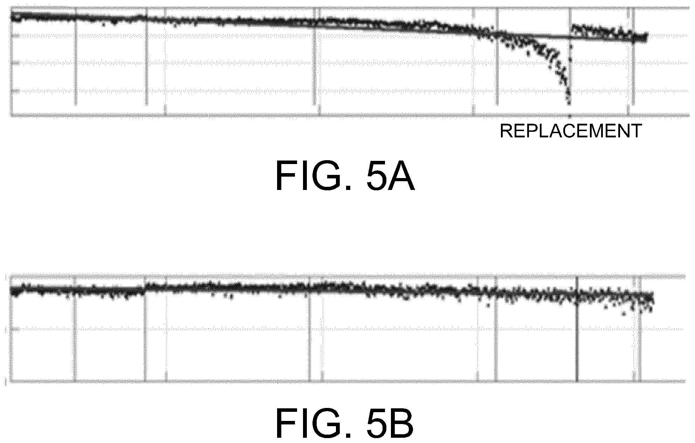

The detection of the deteriorating acceleration based on the SoH, the maximum/minimum voltage SoH and the SoH ratio will be described. FIG. 4 (FIGS. 4A and 4B) is a chart illustrating transitions of the SoH. FIG. 5 (FIGS. 5A and 5B) is a chart illustrating transitions of the maximum/minimum voltage SoH. The axes of abscissas in FIGS. 4 and 5 indicate charging/discharging equivalent cyclenumber, and FIGS. 4 and 5 illustrate plots with respect to, e.g., one battery board on the daily basis. The equivalent cycle number is a numerical value obtained by dividing an stored charging/discharging electric power energy by electric power energy given in the specifications of the battery board, and represents how many times the electric power energy applied to the battery board so far corresponds to the full-charge capacity of the battery board. FIG. 4A and FIG. 5A each illustrate the maximum/minimum SoH of the battery board, and FIG. 4B and FIG. 5B each illustrate the SoH of the battery board. FIG. 4 depicts a case in which the deteriorations of the units configuring the battery board are relatively uniform, whereas FIG. 5 depicts a case in which the deteriorations of the units configuring the battery board are different in terms of progress. Straight lines depicted in FIGS. 4 and 5 represent approximate curves formed by all of the plots.

The plots gradually get away from the approximate curves in FIGS. 4A and 5A. Accordingly, replacement is carried out at a time point of getting away to some extent from the approximate curve. It is thus feasible to detect the deterioration by comparing with the approximate curve, i.e., comparing the respective battery units with each other in a case where the deterioration of the battery unit is different from those of other battery units.

However, as in FIGS. 4B and 5B, the plots don't get away from the approximate curve in a case where the battery unit is deteriorated in the same way as other battery units are deteriorated. In other words, it is unfeasible to detect the deterioration even by comparing the respective battery units with each other. The deterioration is undetectable relatively, and hence the deterioration needs to be detected relatively by providing specific threshold values or threshold functions corresponding to the equivalent cycle number . However, it is difficult to predict how much the deterioration progresses at which time point. For example, the deterioration does not necessarily decrease linearly. When a too strict value is set, a misdetection might be caused, and it is difficult to set an adequate threshold value.

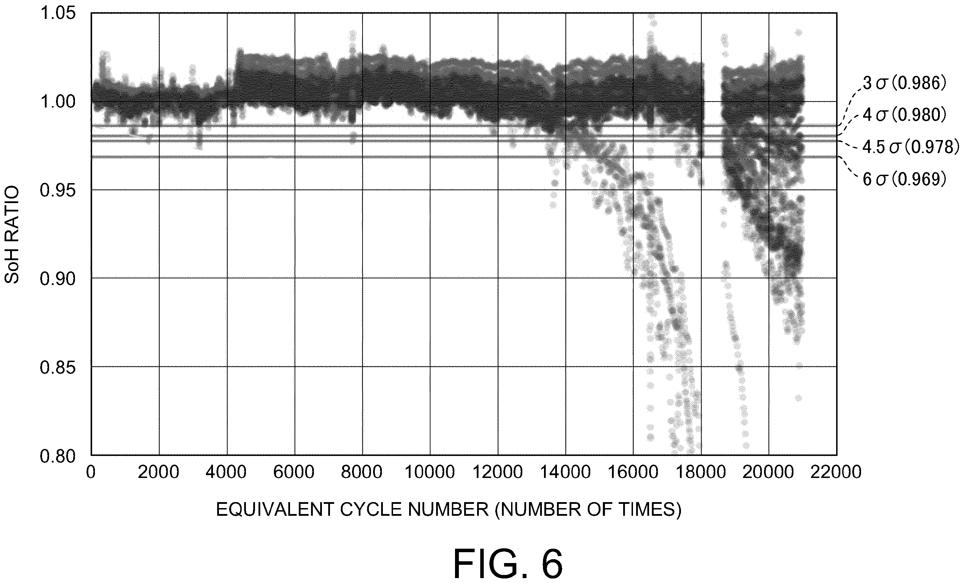

FIG. 6 is a chart illustrating transitions of the SoH ratio. FIG. 6 illustrates the plots for all of the battery boards (several tens of battery boards in the illustrative example). There are neither differences of deterioration between the cells or the battery subunits in the respective battery unit nor the differences of the voltages applied thereto at an initial stage with a small cycle frequency, the maximum/minimum voltage SoH takes substantially the same value as the value of the SoH in each battery unit. Consequently, as illustrated in FIG. 6, the SoH ratio becomes substantially "1" at the initial stage with the small cycle frequency. When there comes out the cell or the battery subunit thereafter, of which the deterioration progresses farther than others, the electric power applied thereto at the charging/discharging time comes to have a dispersion. Accordingly, a difference is caused between the maximum/minimum voltage SoH and the SoH. Consequently, the SoH ratio deviates from "1". It may be detected based on a degree of this deviation that the deterioration of a part of units is accelerated. The SoH ratio is not derived from the comparisons with other battery boards, and hence the deterioration is detectable even when each battery unit gets deteriorated in the same way as other battery units.

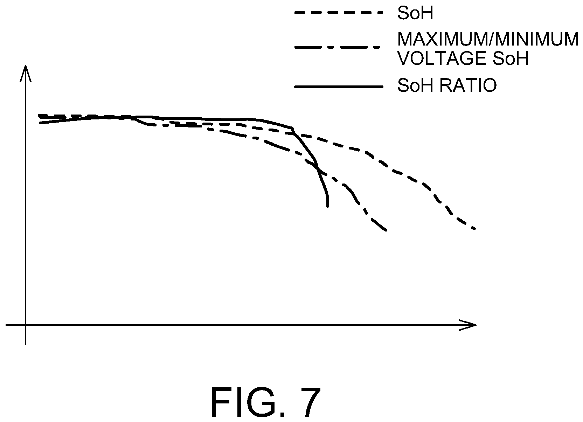

FIG. 7 is a graphic chart illustrating comparisons between the SoH, the maximum/minimum voltage SoH and the SoH ratio. A graph of solid line represents a transition of the SoH ratio. A graph of one-dotted broken line represents a transition of the maximum/minimum voltage SoH. A graph of broken line represents a transition of the SoH. As illustrated in FIG. 7, the SoH ratio drops down more sharply than the transitions of the SoH and the maximum/minimum voltage SoH. It is therefore feasible to enhance the accuracy of detecting the deteriorating acceleration of each battery unit to a greater degree than when using the SoH and the maximum/minimum voltage SoH.

The deterioration is detected based on how far the SoH ratio deviates from "1", and however, the threshold value for this detection may be previously stored in the storage 11. Alternatively, a deterioration estimator may calculate the threshold value. For instance, a standard deviation σ of the SoH ratio in a fixed period is calculated, and the threshold value may also be calculated based on the standard deviation σ. For example, the standard deviation σ of the SoH ratio, which is calculated in the fixed period, is set as a reference dispersion, and standard deviation multiples 3σ,4σ,4.5σ,6σ may also be set as the threshold values. The period for obtaining the standard deviation may be an initial period for which the SoH is assumed to be substantially "1" and may also be a period with its central point being the time point when detecting the deteriorating acceleration.

The detector may detect the deteriorated battery unit from the plurality of battery units on the basis of the calculated SoH or maximum/minimum voltage SoH. The detector 14 may select one of a plurality of categories related to the deterioration on the basis of at least any one of the SoH, the maximum/minimum voltage SoH and the SoH ratio. Predetermined are, e.g., the categories exemplified by "normal", "a part of battery unit has a tendency of the deteriorating acceleration" and "the whole battery unit has the tendency of the deteriorating acceleration", and "value ranges corresponding to these categories". It is then detected that any one of the SoH, the maximum/minimum voltage SoH and the SoH ratio corresponds to which category. Alternatively, the detection about which category the SoH, the maximum/minimum voltage SoH or the SoH ratio corresponds to, may be made based on at least two combinations of the SoH, the maximum/minimum voltage SoH and the SoH ratio. For instance, the SoH is equal to or larger than a predetermined threshold value, and the SoH ratio is smaller than the predetermined threshold value, in which case the category for prompting a user to be cautious may also be selected. Thus, the battery unit, when conforming with a plurality of conditions, may be detected as the alert target. Note that the value ranges may be properly determined, and the values of the ranges may also be set as values based on the standard deviation described above.

The input-and-output circuit 15 outputs the processing results of the respective components. The input-and-output circuit 15 may output, e.g., the calculated SoH, the calculated maximum/minimum voltage SoH and the calculated SoH ratio. The input-and-output circuit 15 may also output a result of detecting the deteriorating acceleration. The input-and-output circuit 15 may further output information indicating the alert, in other words, "Alert" in order to notify the user that the battery unit deemed as the alert target is detected. The input-and-output circuit 15 may also output an identification number exemplified by ID of the battery unit deemed as the alert target. When no battery unit deemed as the alert target exists, the input-and-output circuit 15 may output information indicating "normal" to the user. The input-and-output circuit 15 may further output data exemplified by the measurement data stored in the storage 11.

The output contents may be varied corresponding to the categories about the alert targets. For example, the input-and-output circuit 15 outputs the alert about the battery unit when detecting the deteriorated battery unit on the basis of the SoH or the maximum/minimum voltage SoH, and may also output the alert about the cell or the battery subunit in order to indicate that the cell or the battery subunit in the battery unit has a trouble when detecting the deteriorated battery unit on the basis of the SoH ratio.

Output formats of the input-and-output circuit 15 are not particularly limited, but, e.g., images and sounds/voices may be available. The output formats may be varied corresponding to the detection results of the deteriorating acceleration. For instance, at least one of a plurality alert images and sounds/voices stored beforehand in the storage 11 may be outputted corresponding to the assumed category.

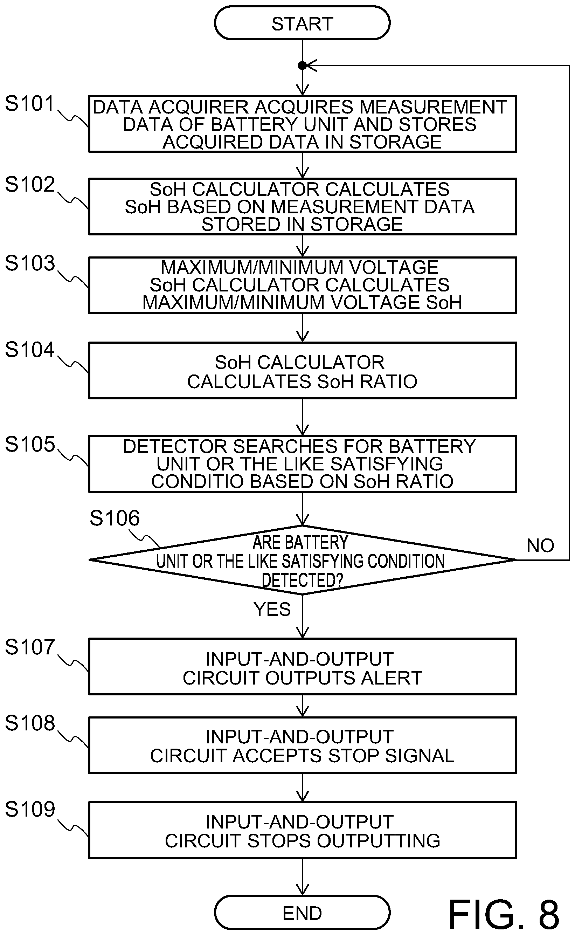

Next, processing flows of the components will be described. FIG. 8 is an outline flowchart of whole processes of the information processing apparatus 1 according to the embodiment.

The data acquirer acquires the measurement data related to the battery unit and stores the acquired data in the storage 11 (S101). The SoH calculator 131 calculates the SoH, based on the measurement data stored in the storage 11 (S102). As described above, specifically, the standard deviation or the equivalent of the distribution of the voltage values is calculated from the time-series data of voltages in the measurement data, and the corresponding SoH may be acquired from the reference data.

The maximum/minimum voltage SoH calculator 132 calculates the maximum/minimum voltage SoH, based on the measurement data stored in the storage 11. The maximum/minimum voltage SoH may be calculated by using the voltage when calculating the SoH, i.e., the maximum voltage at the charging time and the minimum voltage at the discharging time, as described above (S103).

The SoH ratio calculator 133 calculates the SoH ratio on the basis of the calculated SoH and maximum/minimum voltage SoH (S104). The detector 14 makes a search for whether the battery unit satisfying a condition about outputting the alert exist or not, based on the calculated SoH ratio or the equivalent (S105). The condition may be properly determined, and may also be a condition about, e.g., the SoH ratio, and may further be a condition about the SoH. The condition may be exemplified by whether the SoH ratio or the equivalent decreases under the predetermined threshold value or not, and whether the SoH ratio or the equivalent falls within a predetermined range or not.

When not satisfying the condition (NO in S106), the processing loops back to the process in S101. Then, the data acquirer again acquires the measurement data, and the SoH ratio is calculated. When the battery unit satisfying the condition exist (YES in S106), the input-and-output circuit 15 outputs the alert-related images or sounds/voices (S107). Subsequently, the input-and-output circuit 15 accepts stop signals outputted from the user, other apparatuses and other components (S108) and thus stops outputting, thereby finishing the processing flow.

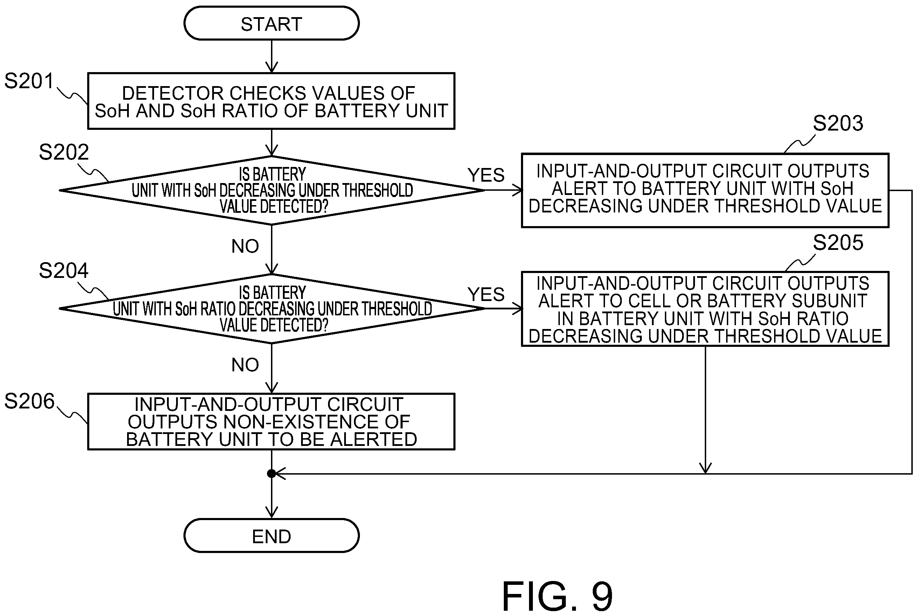

Specific examples of the detection and the output will be further given. FIG. 9 is an outline flowchart illustrating the specific examples of the detection and the output. This processing flow illustrates the processes in S105 to S107 depicted in FIG. 8 by way of more practical processes.

To start with, the detector 14 checks the values of the SoH and the SoH ratio of each battery unit, which are calculated by the calculator 13 (S201). When detecting the battery unit with the calculated SoH being under the threshold value (YES in S202), the input-and-output circuit 15 outputs the alert against the battery unit with the SoH being under the threshold value. For example, the input-and-output circuit 15 may specify which battery unit is under the threshold value by indicating the identification number or the equivalent of the battery unit.

Whereas when detecting none of the battery units with the calculated SoH being under the threshold value (NO in S202), it is checked whether the battery unit with the SoH ratio being under the threshold value is detected or not. When detecting the battery unit with the calculated SoH ratio being under the threshold value (YES in S204), the input-and-output circuit 15 outputs the alert against the cell or the battery subunit in the battery unit with the SoH ratio being under the threshold value (S205). In other words, this indicates that any one of the cell and the battery subunit in the battery unit has the trouble. Not the indication that the whole battery unit has the trouble but the indication that the internal cell or battery subunit has the trouble, may thus be made.

Whereas when detecting none of the battery units with the calculated SoH ratios each being under the threshold value (NO in S204), there are not the battery units or the equivalents to be alerted, and hence the input-and-output circuit 15 outputs information representing this effect (S206). Note that it is not necessary to indicate that all of the rechargeable battery, the battery units, the battery subunits and the cells are normal. The normality indicating targets may be properly determined in conformity with monitoring rules.

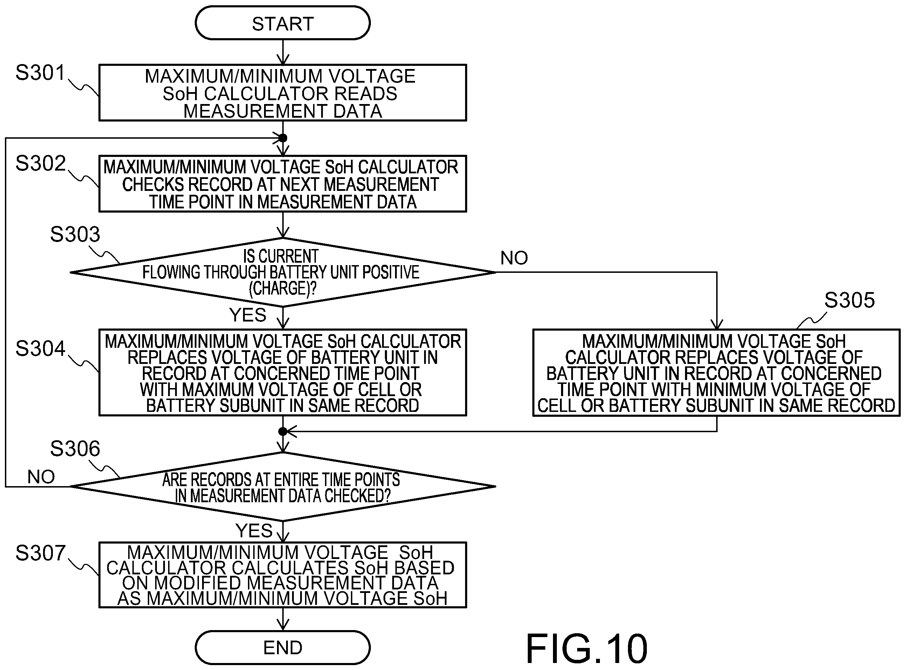

A processing flow of calculating the maximum/minimum voltage SoH will also be described for the sake of understanding the calculation of the maximum/minimum voltage SoH. FIG. 10 is an outline flowchart illustrating processes of calculating the maximum/minimum voltage SoH. This processing flow represents details of S103 illustrated in FIG. 8. The maximum/minimum voltage SoH calculator is a main unit handling the present processing flow.

The maximum/minimum voltage SoH calculator reads the measurement data (S301). In the measurement data, values of measurement items exemplified by the voltage and the current at the respective measuring time points are herein given in rows (records). The maximum/minimum voltage SoH calculator checks the record at the next measuring time point (S302). The record at the first measuring time point is checked in a first process of S302.

When the current flowing through the battery unit in the record concerned is positive, i.e., when the battery unit is charged with the current (YES in S303), the voltage of the battery unit in the record at the time point concerned is replaced by a maximum value in the voltages of the cells or the battery subunits in the same record (S304). When the current flowing through the battery unit in the record is not positive, i.e., when the battery unit is discharged (NO in S303), the voltage of the battery unit in the record at the time point is replaced by a minimum value in the voltages of the cells or the battery subunits in the same record (S305).

When not checking the records at all of the time points in the measurement data (NO in S306), the processing loops back to the process in S302, and the record at the next measuring time point is checked. The process in S304 or S305 is thus executed for all of the records in the measurement data. When checking the records at all of the time points in the measurement data (YES in S306), it is finished to modify the measurement data, and hence the maximum/minimum voltage SoH calculator calculates the SoH on the basis of the modified measurement data, and sets the calculated SoH as the maximum/minimum voltage SoH (S307). Thus, the voltage of the battery unit is replaced by the maximum voltage or the minimum voltage of the cells or the battery subunits, corresponding to the charge/discharge of the battery unit, thereby calculating the maximum/minimum voltage SoH.

Each of the flowcharts in FIGS. 8 to 11 is one example, in which the flowcharts are not limited to those given above. Sequences or the equivalents of the processes are not limited, but a part of the processes may be omitted. For example, as described above, the external apparatus detects the deteriorating acceleration, in which case it may be sufficient that the input-and-output circuit 15 outputs the SoH ratio or the equivalent. The processes in S102 and S103 may be executed in parallel. When not accepting the signal for stopping the output, the processing may again loop back to the process in S101 without stopping the output. The SoH and the SoH ratio are used in the processing flow of FIG. 9, and however, the alert against the maximum/minimum voltage SoH may be outputted after checking the maximum/minimum voltage SoH.

As described above, according to the embodiment, the use of the SoH ratio enables the battery unit progressing in its deterioration farther than other battery units to be detected from the plurality of battery units included in the rechargeable battery 2. It is thereby feasible to detect the battery unit having a high risk of the failure earlier than by the conventional methods even when exhibiting a small bias in the deteriorations of the plurality of battery units. There is no necessity for comparing the SoH ratio with those of other battery units, and therefore a dispersion of initial performance due to Lot of the battery units does not need being taken into consideration.

Note that at least a part of the embodiment described above may be attained by dedicated electronic circuits (i.e., hardware) exemplified by ICs (Integrated Circuits) on which processors, memories and the equivalents are mounted. At least a part of the embodiment described above may also be attained by running software (programs). For instance, a general-purpose computer apparatus is employed as basic hardware, and a processor exemplified by a CPU mounted on the computer apparatus runs the program, thereby enabling the processes in the embodiment to be attained. The information processing apparatus 1 may be configured by, e.g., one or a plurality of computers.

For example, the computer reads the dedicated software stored in a non-transitory computer readable storage medium, thereby enabling the computer to be used as the apparatus according to the embodiment. Categories of the storage mediums are not particularly limited. The dedicated software downloaded via a communication network is installed into the computer, thereby enabling the computer to be used as the apparatus according to the embodiment. The software-based information processing is thus tangibly implemented by use of the hardware resources.

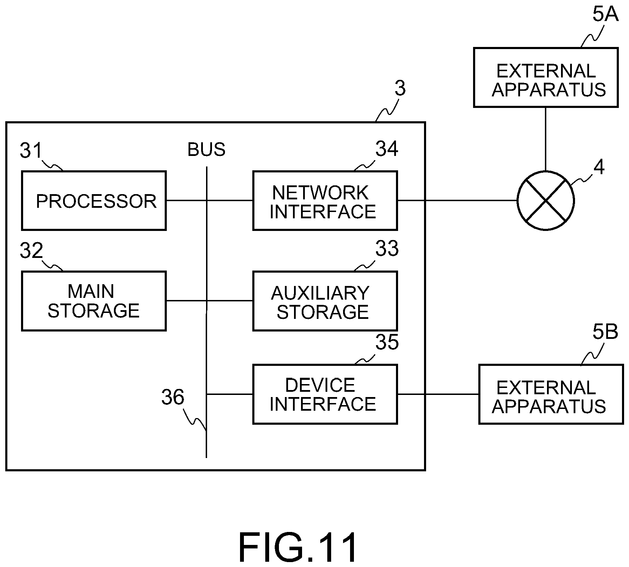

FIG. 11 is a block diagram illustrating one example of a hardware configuration in one embodiment of the present invention. The information processing apparatus 1 includes a processor 31, a main storage 32, an auxiliary storage 33, a network interface 34, and a device interface 35, and may be attained as a computer apparatus 3 by interconnecting these components via a bus 36. The storage 11 may be attained by the main storage 32 or the auxiliary storage 33, and other components may be attained by the processor 31.

Note that the computer apparatus 3 in FIG. 11 includes the respective components by ones and may include a plurality of same components. FIG. 11 illustrates one computer apparatus 3, and however, a plurality of computer apparatuses may respectively execute a different part of processes of software by installing the software into the plurality of computer apparatuses.

The processor 31 is an electronic circuit including a controller and an arithmetic device of the computer. The processor 31 executes an arithmetic process based on the program and the data inputted from the respective devices of the internal configuration of the computer apparatus 3, and outputs an arithmetic result and a control signal to the respective devices. To be specific, the processor 31 executes OS (Operating System) and applications of the computer apparatus 3, thus controlling the respective devices configuring the computer apparatus 3. The processor 31 is not particularly limited on condition that the processor 31 is capable of executing the processes described above.

The main storage 32 is a storage that stores instructions and various items of data to be executed by the processor 31, and the processor 31 directly reads the information stored in the main storage 32. The auxiliary storage 33 is a storage other than the main storage 32. Note that these storage devices are what means arbitrary electronic components capable of storing the electronic information, and may be memories and storages. The memories are classified into volatile and nonvolatile memories, and both of the memories may be available.

The network interface 34 is an interface for establishing wireless or wired connections to the communication network 4. Interfaces conforming with the existing telecommunications standard may be usable as the network interface 34. Through the network interface 34, the information may be received from and transmitted to an external apparatus 5A being communication-connected via the communication network 4.

The device interface 35 is an interface exemplified by a USB that directly connects to an external apparatus 5B. The external apparatus 5B may be an external storage medium and may also be a storage device exemplified by a database.

Each of the external apparatuses 5A and 5B may be a simulator 107, may also be an output apparatus and may further be an input apparatus. The output apparatus may be, e.g., a display apparatus for displaying the images and may also be an apparatus for outputting the sounds/voices. The input and output apparatuses are exemplified by LCD (Liquid Crystal Display), CRT (Cathode Ray Tube), PDP (Plasma Display Panel) and a loudspeaker but are not limited to these apparatuses. The input apparatus includes devices exemplified by a keyboard, a mouse and a touch panel, and gives pieces of information inputted by these devices to the computer apparatus 3. Signals coming from the input apparatus are outputted to the processor 31.

Although one embodiment of the present invention has been described above, the embodiments thereof have been given by way of examples but are not intended to limit the scope of the invention. These novel embodiments can be carried out in a variety of other modes; and varieties of omissions, replacements and transitions can be made within the scope that does not depart from the gist of the invention. These embodiments and modifications thereof are included in the invention claimed in the scope of claims and the equivalent scope thereof as well as being embraced by the scope and the gist of the invention.

### Brief Description of the Reference Numerals and Symbols

- 1: information processing apparatus
- 11: storage
- 12: data acquirer
- 13: calculator
- 14: detector
- 15: input-and-output circuit
- 2: rechargeable battery
- 21: unit battery (cell)
- 22: battery module
- 23: battery board
- 3: computer apparatus
- 31: processor
- 32: main storage
- 33: auxiliary storage
- 34: network interface
- 35: device interface
- 36: bus
- 4: communication network
- 5(5A, 5B): external apparatus

## Claims

1. An information processing apparatus comprising:
an SoH calculator to calculate an SoH (State of Health) for each of a plurality battery units on the basis of measurement data related to an electric power applied to each of the plurality of battery units in a rechargeable battery;
a maximum/minimum voltage SoH calculator to calculate a maximum/minimum voltage SoH which is an SoH based on a maximum voltage and a minimum voltage in voltages applied to a plurality of cells or a plurality of battery subunits in the battery unit for each of the plurality of battery units on the basis of the measurement data; and
an SoH ratio calculator to calculate an SoH ratio which is a ratio of the maximum/minimum voltage SoH to the SoH for each of the plurality of battery units on the basis of the calculated SoH and the calculated maximum/minimum voltage SoH.

2. The information processing apparatus according to claim1, wherein the calculated SoH ratio of the battery unit represents how much the cell or the battery subunit in which deterioration most progresses in the battery unit progresses in deterioration compared with other cells or battery subunits in the battery unit.

3. The information processing apparatus according to claim 1 or 2, further comprising a detector to detect an alert target battery unit from the plurality of battery units on the basis of the SoH ratio of each of the plurality of battery units.

4. The information processing apparatus according to claim 3, wherein the detector detects the alert target battery unit from the plurality of battery units, based on a degree of how much each SoH ratio deviates from a value "1".

5. The information processing apparatus according to claim 3, wherein the detector calculates a standard deviation of SoH ratios calculated at a plurality time points within a predetermined period for each of the battery units, determines a threshold value on the basis of the standard deviation, and detects the alert target battery unit by comparing the SoH ratio with the threshold value after an elapse of the predetermined period.

6. The information processing apparatus according to claim 5, wherein the detector determines the threshold value by multiples of the standard deviation.

7. The information processing apparatus according to any one of claims 3 to 6, wherein the detector determines the rechargeable battery to be the alert target when the alert target battery unit is detected.

8. The information processing apparatus according to any one of claims 3 to 7, wherein the detector detects a deteriorated battery unit from the plurality of battery units on the basis of the calculated SoH or the calculated maximum/minimum voltage SoH.

9. The information processing apparatus according to claim 8, further comprising an output circuit to output information indicating an alert corresponding to the deteriorated battery unit when the deteriorated battery unit is detected based on the SoH, and to output information indicating an alert corresponding to the cell or the battery subunit in the alert target cell when the alert target battery unit is detected based on the SoH ratio.

10. The information processing apparatus according to claim 9, wherein the output circuit outputs information indicating that at least any one of the rechargeable battery, the battery unit, the battery subunit and the cell is normal when the deteriorated battery unit is not detected based on the SoH and when the alert target battery unit is not detected based on the SoH ratio.

11. The information processing apparatus according to claim 8, further comprising an output circuit to output information indicating that at least any one of the rechargeable battery, the battery unit, the battery subunit and the cell is normal when the deteriorated battery unit is not detected based on the SoH and when the alert target battery unit is not detected based on the SoH ratio.

12. The information processing apparatus according to any one of claims 3 to 8, further comprising an output circuit to output information on a processing result of at least any one of the SoH calculator, the maximum/minimum voltage SoH calculator, the SoH ratio calculator and the detector.

13. The information processing apparatus according to claim 12, wherein the detector selects one of categories corresponding to a plurality of alerts for at least any one of the rechargeable battery, the battery unit, the battery subunit and the cell on the basis of at least any one of the SoH, the maximum/minimum voltage SoH and the SoH ratio, and
the output circuit outputs information indicating the selected category.

14. The information processing apparatus according to any one of claims 1 to 13, wherein the maximum/minimum voltage SoH calculator calculates the maximum/minimum voltage SoH of the battery unit by using the maximum voltage instead of the voltage of the battery unit when charging the battery unit and by using the minimum voltage instead of the voltage of the battery unit when discharging the battery unit.

15. The information processing apparatus according to any one of claims 1 to 14, wherein the SoH is a ratio of a full-charge capacity at an evaluation time point to a full-charge capacity defined in specification of the battery unit.

16. The information processing apparatus according to any one of claims 1 to 15, wherein the SoH is a ratio of a full-charge capacity at a second time point time pointto a full-charge capacity at a first time point of the battery unit.

17. The information processing apparatus according to any one of claims 1 to 16, wherein the SoH calculator calculates the SoH on the basis of a general relationship between an SoH and a standard deviation or a variance of voltage values for a unit period with respect to the battery unit.

18. An information processing method comprising:
calculating an SoH (State of Health) for each of a plurality battery units on the basis of measurement data related to an electric power applied to each of the plurality of battery units in a rechargeable battery;
calculating a maximum/minimum voltage SoH which is an SoH based on a maximum voltage and a minimum voltage in voltages applied to a plurality of cells or a plurality of battery subunits in the battery unit for each of the plurality of battery units on the basis of the measurement data; and
calculating an SoH ratio which is a ratio of the maximum/minimum voltage SoH to the SoH for each of the plurality of battery units on the basis of the calculated SoH and the calculated maximum/minimum voltage SoH.

19. A computer program which causes a computer to perform processes comprising:
calculating an SoH (State of Health) for each of a plurality battery units on the basis of measurement data related to an electric power applied to each of the plurality of battery units in a rechargeable battery;
calculating a maximum/minimum voltage SoH which is an SoH based on a maximum voltage and a minimum voltage in voltages applied to a plurality of cells or a plurality of battery subunits in the battery unit for each of the plurality of battery units on the basis of the measurement data; and
calculating an SoH ratio which is a ratio of the maximum/minimum voltage SoH to the SoH for each of the plurality of battery units on the basis of the calculated SoH and the calculated maximum/minimum voltage SoH.

20. An information processing system comprising:
a rechargeable battery; and
an information processing apparatus, wherein
the rechargeable battery comprises a plurality of battery units,
each of the battery units comprises a plurality of cells or a plurality of battery subunits,
the information processing apparatus comprises
an SoH calculator to calculate an SoH (State of Health) for each of the plurality battery units on the basis of measurement data related to an electric power applied to each of the plurality of battery units in the rechargeable battery;
a maximum/minimum voltage SoH calculator to calculate a maximum/minimum voltage SoH which is an SoH based on a maximum voltage and a minimum voltage in voltages applied to the plurality of cells or the battery subunits in the battery unit for each of the plurality of battery units on the basis of the measurement data; and
an SoH ratio calculator to calculate an SoH ratio which is a ratio of the maximum/minimum voltage SoH to the SoH for each of the plurality of battery units on the basis of the calculated SoH and the calculated maximum/minimum voltage SoH.
